(19) Europäisches Patentamt
European Patent Office
Office européen des brevets

(11) EP 3 049 505 B1

(12) EUROPEAN PATENT SPECIFICATION

(45) Date of publication and mention of the grant of the patent:
**14.12.2016 Bulletin 2016/50**

(51) Int Cl.:
*C09K 11/77* (2006.01)    *H05B 33/14* (2006.01)
*C09K 11/08* (2006.01)

(21) Application number: **14772123.7**

(86) International application number:
**PCT/EP2014/070184**

(22) Date of filing: **23.09.2014**

(87) International publication number:
**WO 2015/044106 (02.04.2015 Gazette 2015/13)**

(54) **NEW NITRIDOALUMOSILICATE PHOSPHOR FOR SOLID STATE LIGHTING**

NEUES NITRIDOALUMOSILICATPHOSPHOR FÜR FESTKÖRPERBELEUCHTUNG

NOUVEAU PHOSPHORE DE NITRIDOALUMOSILICATE POUR ÉCLAIRAGE À SEMI-CONDUCTEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2013 EP 13186161**

(43) Date of publication of application:
**03.08.2016 Bulletin 2016/31**

(73) Proprietor: **Koninklijke Philips N.V.**
**5656 AE Eindhoven (NL)**

(72) Inventors:
• **TÜCKS, Andreas**
  NL-5656 AE Eindhoven (NL)
• **SCHREINEMACHER, Baby-Seriyati**
  NL-5656 AE Eindhoven (NL)
• **SCHMIDT, Peter Josef**
  NL-5656 AE Eindhoven (NL)
• **SCHMIECHEN, Sebastian, Florian**
  NL-5656 AE Eindhoven (NL)
• **SCHNICK, Wolfgang**
  NL-5656 AE Eindhoven (NL)

(74) Representative: **ter Heegde, Paul Gerard Michel**
**Lumileds Germany GmbH**
**Philipsstraße 8**
**52068 Aachen (DE)**

(56) References cited:
EP-A1- 1 666 563        EP-A1- 1 930 393
CN-A- 101 760 194       US-A1- 2012 080 999

• **KEYONG NAM LEE ET AL: "Sol-Gel Synthesis of an Efficient Blue CaMgSi[sub 2]O[sub 6]:Eu[sup 2+] Thin-Film Phosphor with Two-Dimensional Triangular-Lattice SiN[sub x] Air-Hole Photonic Crystal", JOURNAL OF THE ELECTROCHEMICAL SOCIETY, vol. 156, no. 9, 22 July 2009 (2009-07-22) , page J283, XP055106216, ISSN: 0013-4651, DOI: 10.1149/1.3174388**
• **CORA HECHT ET AL: "SrAlSi 4 N 7 :Eu 2+ - A Nitridoalumosilicate Phosphor for Warm White Light (pc)LEDs with Edge-Sharing Tetrahedra", CHEMISTRY OF MATERIALS, vol. 21, no. 8, 28 April 2009 (2009-04-28) , pages 1595-1601, XP055077550, ISSN: 0897-4756, DOI: 10.1021/cm803231h**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The invention relates to a class of new phosphors, as well as individual members thereof, and to a lighting unit comprising one or more of such phosphors, and optionally one or more other phosphors, for generating luminescence.

BACKGROUND OF THE INVENTION

Green/yellow luminescent materials for LED (light emitting device) applications are known in the art. US2006011922, for instance, describes a light emitting device comprising a light emitting structure capable of emitting primary light of a wavelength less than 480 nm and a luminescent screen comprising a phosphor of general formula $(Sr_{1-a-b}Ca_bBa_cMg_dZn_e)Si_xN_yO_z:Eu_a$, wherein $0.002<=a<=0.2$, $0.0<=b<=0.25$, $0.0<=c<=0.25$, $0.0<=d<=0.25$, $0.0<=e<=0.25$, $1.5<=x<=2.5$, $1.5<=y<=2.5$ and $1.5<=z<=2.5$. This document also concerns a luminescent screen comprising such phosphor, as well as the phosphor per se.

Further phosphors are described in EP 1 930 393 and EP 1 666 563.

SUMMARY OF THE INVENTION

There is still a need for obtaining good inorganic luminescent materials that can replace or supplement existing luminescent materials, such as for solid state lighting, for instance because of better efficiency or other advantageous luminescent properties like excitation and/or emission band position and/or emission bandwidth.

Hence, it is an aspect of the invention to provide an alternative phosphor, especially an alternative green-yellow phosphor, which preferably further at least partly obviates one or more of above-described drawbacks, which preferably absorbs well in the blue and/or UV, especially in the blue, and/or which efficiently converts the absorbed light into visible light, especially green-yellow light. However, other colors (in the visible) may be of interest as well, like cyan or orange. It is further an aspect to provide an alternative lighting unit, configured to use such alternative phosphor (for instance as luminescent material, optionally in combination with other phosphors).

Herein, a new class of materials is proposed, with surprising good optical properties. A new class of phosphor materials described by the general composition $M_{1-x-y-z}Z_zA_aB_bC_cD_dE_eN_{6-n}O_n:ES_x,RE_y$, where M is a divalent element selected from Ca (calcium), Sr (strontium), Ba (barium), Z is a monovalent element selected from Na (sodium), K (potassium), Rb (rubidium), A is a monovalent element selected from Li (lithium), Cu (copper), B is a divalent element selected from Mg (magnesium), Mn (manganese), Zn (zinc), Cd (cadmium), C is a trivalent element selected from B (boron), Al (aluminum), Ga (gallium), D is a tetravalent element selected from Si (silicon), Ge (germanium), Ti (titanium), Hf (hafnium), E is a pentavalent element selected from P (phosphorous), V (vanadium), Nb (niobium), Ta (tantalum), ES is a divalent rare earth element selected from Eu (europium), Sm (samarium) and Yb (ytterbium), RE is a trivalent rare earth element selected from Ce (cerium), Pr (praseodymium), Nd (neodymium), Sm (samarium), Eu (europium), Gd (gadolinium), Tb (terbium), Dy (dysprosium), Ho (holmium), Er (erbium), Tm (thulium) has been found. The compositional range is further especially defined by $0 \le x \le 0.2$, $0 \le y \le 0.2$, especially $0 < x+y \le 0.4$, $0 \le z < 1$, $x + y + z < 1$, especially $0 \le n < 0.75$, $a + b = 2$, $c + d + e = 4$, and $a + 2b + 3c + 4d + 5e + y- z = 16-n$.

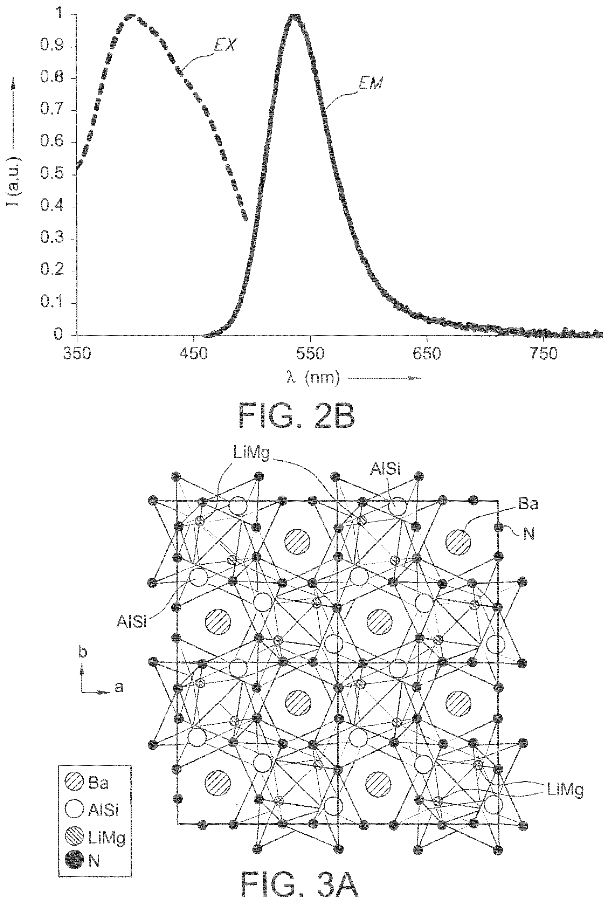

These compounds crystallize in a new crystal structure (figures 3a-3c) that has hitherto not been described in the literature. In this structure, M and Z are coordinated by 8 N ligands (twisted cube), while A, B, C, D, and E are located in corner and edge-sharing $[XN_4]$ tetrahedra (X = A, B, C, D, E). The resulting highly condensed host lattice can be modified by interchanging cations of appropriate size (see table 1 below). These substitutions result in changes in bond lengths (causing changes in lattice parameters) and changes in polarization of cation-ligand bonds that also affect the energy states of activator ions in the lattice. Therefore it is possible to shift the emission band of e.g. $BaLi_2Al_2Si_2N_6:Eu$ towards longer peak wavelengths by substituting Si by Al to increase the charge density of the Eu-coordinating ligands (charge compensation in the A/B sublattice, e.g. Mg replacing Li) or by substituting Ba by cations that cause a shrinkage of the lattice and a shortening of activator-ligand distances. Increasing the Eu concentration results in a red-shifted and broadened emission profile, which is a well-known effect for many $Eu^{2+}$ phosphors. The different effects of cation size and charge combined with the influence of different types of cation sites in the lattice (A, B vs. C, D, E) enables a variety of tuning options for the spectral emission shape and position.

Hence, in a first aspect, the invention provides a lighting unit comprising a light source, configured to generate light source light and a luminescent material, configured to convert at least part of the light source light into luminescent material light, wherein the light source comprises a light emitting diode (LED), or optionally (or additionally) another light source, and wherein the luminescent material comprises a phosphor having the (chemical) formula $M_{1-x-y-z}Z_zA_aB_bC_cD_dE_eN_{6-n}O_n:ES_x,RE_y$ (phosphor having formula (I)), with M = selected from the group consisting of Ca (calcium), Sr (strontium), and Ba (barium); Z selected from the group consisting of monovalent Na (sodium), K (potassium), and Rb (rubidium); A selected from the group consisting of monovalent Li (lithium), and Cu (copper); B selected from the group consisting of divalent Mg (magnesium), Mn (manganese), Zn (zinc), and Cd (cadmium) (especially, B selected from the group consisting of divalent Mg (magnesium), Mn (manganese), and Zn (zinc), even more especially selected from the group consisting of divalent Mg (magnesium), Mn (manganese); C selected from the group consisting of trivalent B (boron), Al (aluminum) and Ga (gallium); D selected from the group consisting of tetravalent Si (silicon), Ge (germanium), Ti (titanium) and Hf (hafnium); E selected from the group consisting of P (the element phosphor), V (vanadium), Nb (niobium), and Ta (tantalum); ES selected from the group consisting of divalent Eu (europium), Sm (samarium) and Yb (ytterbium), especially selected from the group consisting of divalent Eu and Sm; RE selected from the group consisting of trivalent Ce (cerium), Pr (praseodymium), Nd (neodymium), Sm (samarium), Eu (europium), Gd (gadolinium), Tb (terbium), Dy (dysprosium), Ho (holmium), Er (erbium), and Tm (thulium); especially with $0 \leq x \leq 0.2$; $0 \leq y \leq 0.2$; $0 < x+y \leq 0.4$; $0 \leq z < 1$; $x + y + z < 1$; especially $0 \leq n \leq 0.75$; $0 \leq a \leq 2$; $0 \leq b \leq 2$; $0 \leq c \leq 4$; $0 \leq d \leq 4$; $0 \leq e \leq 4$; $a + b = 2$; $c + d + e = 4$; and $a + 2b + 3c + 4d + 5e + y - z = 16 - n$. Especially, $z \leq 0.9$, such as $z \leq 0.5$, especially $z=0$. Further, especially $x+y+z \leq 0.2$. Such phosphor surprisingly may have a very high efficiency and a relatively narrow emission band with (see also below).

The phosphor, when illuminated by the light source light, thus converts at least part of the light source light into luminescent material light (emission). The luminescent material light thus contains luminescence from the phosphor (with formula (I)), and optionally of other phosphors (see also below).

In a second aspect, the invention also provides such phosphor *per se*, i.e. a phosphor having the formula $M_{1-x-y-z}Z_zA_aB_bC_cD_dE_eN_{6-n}O_n:ES_x,RE_y$ (I), with M selected from the group consisting of divalent Ca, Sr, and Ba; Z selected from the group consisting of monovalent Na, K, and Rb; A selected from the group consisting of monovalent Li, and Cu; B selected from the group consisting of divalent Mg, Mn, Zn, and Cd (especially B selected from the group consisting of divalent Mg, Mn, and Zn; even more especially selected from the group consisting of Mg and Mn, especially Mg); C selected from the group consisting of trivalent B, Al and Ga; D selected from the group consisting of tetravalent Si, Ge, Ti, and Hf; E selected from the group consisting of P, V, Nb, and Ta; ES selected from the group consisting of divalent Eu, Sm and Yb, especially selected from the group consisting of divalent Eu and Sm; RE selected from the group consisting of trivalent Ce, Pr, Nd, Sm, Eu, Gd, Tb, Dy, Ho, Er, and Tm; with especially $0 \leq x \leq 0.2$; $0 \leq y \leq 0.2$; $0 < x+y \leq 0.4$; $0 \leq z < 1$; $x + y + z < 1$; $0 \leq n \leq 0.75$; $0 \leq a \leq 2$; $0 \leq b \leq 2$; $0 \leq c \leq 4$; $0 \leq d \leq 4$; $0 \leq e \leq 4$; $a + b = 2$; $c + d + e = 4$; and $a + 2b + 3c + 4d + 5e + y - z = 16 - n$.

The invention also relates to a luminescent material at least comprising this phosphor and optionally one or more other materials, like one or more other phosphors and/or one or more other phases like (remaining) flux material. The phosphor may also include impurities, like one or more of halogen impurities and metal impurities. The luminescent material, may next to the one or more phosphors as defined herein, also include other phases, like one or more of the - already indicated (remaining) - flux material, remaining starting material(s) and one or more phases that are also formed during synthesis of the one or more (respective) phosphors. Likewise, the phosphor may also include other phases, like one or more of the - already indicated (remaining) - flux material, remaining starting material(s) and one or more phases that are also formed during synthesis of the one or more (respective) phosphors. In general, the weight percentage of such other phase(s) will be below about 10 wt.% (relative to the total weight of the phosphor).

As indicated above, the phosphor may also include impurities. This is known in the art. Hence, in embodiments chemical formulas like, such as defined below, etc., do not exclude the presence of impurities, for instance up to a total of about 500 ppm, especially up to about 200 ppm, even more especially up to about 100 ppm. Hence, even though the chemical formula does not indicate the presence of impurities, impurities that may (nevertheless) be present can for instance be selected from the group consisting of Li, Na, K, Sc, Y, Ti, Zr, V, Nb, Cr, Mo, Mn, Fe, Ru, Co, Rh, Ni, Pd, Cu, Zn, V, C, N, O, F, Al, Si, P, S, Cl, Ga, Ge, Se, Br, Lu, La, Ce, Pr, Nd, Sm, Eu, Gd, Tb, Dy, Ho, Er, Tm, Yb, Hf, Ta, W, Re, Os, Ir, Pt, Tl, Pb, and Bi. Here, impurities are listed. When for instance the chemical formula indicates the availability of Li or Eu, these are - even when available in small amounts - not considered as impurities. Hence, e.g. in $Ba_{0.99}Li_{1.8}Mg_{0.2}Al_{2.2}Si_{1.8}N_6:Eu_{0.01}$, Eu is not an impurity, but $Ba_{0.99}Li_{1.8}Mg_{0.2}Al_{2.2}Si_{1.8}N_6:Eu_{0.01}$ may include e.g. 150 ppm Hf or Na or Mg (as impurity/impurities).

Further, the luminescent material may include one or more of scattering particles and a halide salt, especially at least scattering particles.

Ideally, the green-yellow phosphor component should show an emission peak in the 525 - 565 nm wavelength range with a full-width-half-maximum (FWHM) less than 80 nm. However, as indicated above, also phosphors having other characteristics may be of interest.

The present invention advantageously provides alternative phosphors, which amongst others may advantageously have one or more of the following properties: (1) emitting in one or more parts of the visible spectrum, at least in one or more of the green-yellow, especially the green, (2) having a good efficiency, (3) having a narrow band width (in the green-yellow), and (4) having other advantageous (optical) properties (such as a long life time / high stability).

The term "phosphor" is herein used for any material that upon excitation emits radiation in the visible part of the spectrum. Another term for "phosphor" may be luminescent material, but this term "luminescent material" is herein especially reserved for a material or material mixture comprising at least the phosphor (having formula (I) as defined herein and optionally also one or more other phosphors (see also below).

The term phosphor may in an embodiment relate to a particulate phosphor and in another embodiment relate to a (mono crystalline) phosphor layer. In a specific embodiment, the term phosphor may include a self supporting layer, such as a ceramic polycrystalline material. Likewise, the term "luminescent material" may in an embodiment relate to a particulate "luminescent material" and in another embodiment relate to a (mono crystalline) "luminescent material" layer. In a specific embodiment, the term "luminescent material" may include a self supporting layer, such as a ceramic material. Hence, the term "luminescent material" may in embodiments also refer to a luminescent body.

The term "ceramic" especially relates to an inorganic material that is obtainable by heating a (poly crystalline) powder, like at least 500 °C, especially at least 800 °C, such as at least 1000 °C, under high pressure, such as at least 0.5 MPa, like especially at least 1 MPa, like 1 to about 500 MPa, such as at least 5 MPa, or at least 10 MPa, especially under uniaxial or isostatic pressure, especially under isostatic pressure. A specific method to obtain a ceramic is hot isostatic pressing (HIP), whereas the HIP process may be a post-sinter HIP, capsule HIP or combined sinter-HIP process, like under the temperature and pressure conditions as indicate above. The ceramic obtainable by such method may be used as such, or may be further processed (like polishing, or even processing into particles again). A ceramic especially has density that is at least 90%, such as at least 95%, like in the range of 97-100 %, of the theoretical density (i.e. the density of a single crystal). A ceramic may still be polycrystalline, but with a reduced, or strongly reduced volume between grains (pressed particles or pressed agglomerate particles).

However, also in general, uniaxial or isostatic pressure may be applied to obtain the phosphor. Hence, in an embodiment, the invention also provides a method for producing the herein described phosphor by selecting starting materials in ratios that can lead to at least the desired phosphor and heating under pressure, especially uniaxial or isostatic pressure, even more especially isostatic pressure, the starting materials to produce at least the desired phosphor. Temperatures of especially at least 800 °C may be applied, up to about 1500 °C, and pressures from atmospheric pressure up to the above indicated pressures or even above.

As indicated above and/or as can be derived from the above, the luminescent material, and thus also the ceramic material in case a ceramic luminescent material is applied, may include one or more of the herein described phosphors and optionally one or more of (a) one or more other type of phosphors, (b) one or more other phases formed during synthesis of the one or more of the herein described phosphors (respectively), (c) one or more starting materials used during synthesis of the one or more of the herein described phosphors (respectively), (d) one or more fluxes used during synthesis of the one or more of the herein described phosphors (respectively), (e) one or more scattering materials, and (f) one or more other materials (such as a halide salt).

In an embodiment, the term "phosphor" may relate to a combination of different phosphors all complying with formula (I). The term "formula (I)" may also be indicated as "chemical formula (I)". Hence, the luminescent material at least comprises one or more phosphors having the chemical formula (I) and optionally one or more other phosphors not having this chemical formula (I) (such as e.g. $Y_3Al_5O_{12}:Ce^{3+}$ and/or $Sr_2Si_5N_8:Eu^{2+}$).

The novel phosphors can be made with solid state synthesis methods. Synthesis of the claimed materials can e.g. be carried out by a variety of processing methods. It has been found that keeping firing temperatures low (below ~ 1500 °C, such as below 1400°C) may improve phase purity and luminescence properties of the claimed phases. Hence, the invention also relates to a solid state nitride synthesis method performed at a temperature below 1400 °C, and the phosphors of formula (I) obtainable by such synthesis method. It turned out that reactive precursors like intermetallic phases obtained by melting of the constituent M, Z, A, B, C, D and E metals, alkaline earth amides, or silicon diimide are especially suitable. The addition of flux materials like fluorides or chlorides, especially at least fluorides, may also improve phase formation. Although not explicitly accounted for in the given formulas part of the added halide flux may remain within the phosphor after firing without deteriorating its luminescence properties. The same holds for other impurities like carbon that may to some extend be incorporated into the lattice on nitrogen lattice sites during reactions in e.g. a graphite furnace or by application of a carbon reduction and nitridation (CRN) reaction method. Suitable synthesis methods comprise (a) high pressure nitridation, (b) processing in alkaline metal melts, (c) ammonothermal synthesis and (d) standard mix and fire approaches. In a specific embodiment, one or more of the starting materials comprise hydrides (such as $SrH_2$), and optionally as synthesis method hot isostatic pressing (HIP) is applied. In yet a specific embodiment, one or more of the starting materials comprise hydrides (such as $SrH_2$), and a surplus of earth alkali metal is applied in the form of alkali metal fluoride (such as $SrF_2$), and optionally as synthesis method hot isostatic pressing (HIP) is applied.

Such synthesis methods are known in the art, and are for instance described in Watanabe, et al, Synthesis of Sr0.99Eu0.01AlSiN3 from intermetallic precursor, Journal of the Ceramic Society of Japan 117 (2009) 115-119; Zeuner et al, Li2CaSi2N4 and Li2SrSi2N4 - a Synthetic Approach to Three-Dimensional Lithium Nitridosilicates European Journal of Inorganic Chemistry (2010) 4945-495; and Li et al, Low-Temperature Crystallization of Eu-Doped Red-Emitting CaAlSiN3 from Alloy-Derived Ammonometallates, Chemistry of Materials 19 (2007) 3592-3594.

It appeared that the phosphors of formula (I) which have been made crystallize in tetragonal space group P 4/n c c (No. 130). It is believed that $Eu^{2+}$ or other rare earth cations, like $Ce^{3+}$, are incorporated onto M lattice sites that are coordinated by eight N atoms.

Table 1 lists elements that may be used for host-lattice modifications (substitutions) to obtain new luminescence properties of the present nitridoalumosilicate system. In addition, also e.g. N-O modification may be possible.

Table 1: Selected cations with their effective ionic radii (pm) that can be used to modify the host-lattice of the new nitridoalumo silicate phosphor described in the present invention:

| CN = 8 | | | | CN=4 | | | | | | | | | |
|--------|---|------|-----|-------|----|-------|----|-------|----|------|----|------|------|
| M(II) | | N(I) | | A(II) | | B(III) | | C(IV) | | D(I) | | E(V) | |
| Ca | 126 | Na | 132 | Mg | 71 | B | 25 | Si | 40 | Li | 73 | P | 31 |
| Sr | 140 | K | 165 | Zn | 74 | Al | 53 | Ge | 53 | Cu | 74 | V | 49.5 |
| Ba | 156 | Rb | 175 | Mn | 80 | Ga | 61 | Ti | 56 | | | Nb | 62 |
| | | | | | | | | Zr | 72 | | | Ta | 88 |
| | | | | | | | | Hf | 72 | | | | |

Codoping of alkaline metal containing phosphors as claimed in this invention with both Ce(III) and Eu(II) may lead to phosphors with efficient yellow-green emission and reduced self-absorption of the Eu(II) emission due to low Eu concentrations. An example for such a material is e.g. $Ba_{0.98}Li_2Al_{2.01}Si_{1.99}N_6{:}Eu_{0.01},Ce_{0.01}$.

The equations $a + b = 2$; $c + d + e = 4$; and $a + 2b + 3c + 4d + 5e + y - z = 16 - n$, respectively, especially determine the Z, A, B, C, D and E cations and O and N anions in the lattice and thereby define (also) the charge neutrality of the system. For instance, the charge compensation is covered by the formula $a + 2b + 3c + 4d + 5e + y - z = 16 - n$. It covers e.g. charge compensation by decreasing O content or charge compensation by substituting a D cation by a C cation or a C cation by a B cation, etc. As will be clear to a person skilled in the art, a, b, c, d, e, n, x, y, z are always equal to or larger than zero. When a is defined in combination with the equations $a + b = 2$; $c + d + e = 4$; and $a + 2b + 3c + 4d + 5e + y - z = 16 - n$, then in principle, b, c, d, and e do not need to be defined anymore. However, for the sake of completeness, especially herein also $0 \le a \le 2$; $0 \le b \le 2$; $0 \le c \le 4$; $0 \le d \le 4$; $0 \le e \le 4$ are defined.

Assume a system like $BaLi_2Al_2Si_2N_6{:}Eu$ (with x=0.01 (1% Eu replaces Ba)). Here, a=2, c=d=2, b=e=y=z=n=0. In such system, $x + y + z < 1$, $a + b = 2$, $c + d + e = 4$ and $a + 2b + 3c + 4d + 5e + y - z = 16 - n$. Hence, all equations are complied with. Assume that 0.5 O is introduced. A system with 0.5 O can e.g. be obtained when 0.5 Si-N is replaced by 0.5 Al-O (which is a charge neutral replacement). This would result in $BaLi_2Al_{2.5}Si_{1.5}N_{5.5}O_{0.5}{:}Eu$. Here, also all equations are complied with.

In a further specific embodiment, which may be combined with the former embodiments e=0. In yet a further specific embodiment, which may be combined with the former embodiments, M is Ba and/or Sr, especially M comprises Ba.

In yet a further specific embodiment, the invention provides a coated phosphor. In yet another specific embodiment, the invention provides an embedded phosphor. In the former embodiment, the coated embodiment, especially the phosphor is a particulate phosphor, with phosphor particles comprising a coating. However, the phosphor may also comprise a layer that is coated on one or both sided with a coating. In the latter embodiment, the phosphor may be embedded in an organic or inorganic host material. For instance, the phosphor may comprise a particulate phosphor, wherein the particles of the particulate phosphor are embedded in an organic or inorganic host, like e.g. PMMA, PET, PC, silsesquioxane, glass, etc.

In a specific embodiment, the phosphor comprises an $AlPO_4$ coating. Such coating may e.g. be provided by a method described by Cho et al. (2005) in "Control of AlPO4-nanoparticle coating on LiCoO2 by using water or ethanol", Electrochimica Acta 50, 4182-4187. One or more alternative or additional coatings may include one or more of an $Al_2O_3$ coating and a $SiO_2$ coating.

An $Al_2O_3$ coating may be prepared by e.g. atomic layer deposition (such as e.g. described in Avci, N.; Musschoot, J.; Smet, P.F.; Korthout, K.; Avci, A.; Detavernier, C.; Poelman, D. Microencapsulation of Moisture-Sensitive CaS:Eu2+ Particles with Aluminum Oxide. J. Electrochem. Soc. 2009, 156, J333-J337).

A silica coating may for e.g. be prepared via sol-gel. Such method may include stirring phosphor powder in ethanol with some tetramethoxysilane. Then, concentrated $NH_3$ solution is added. After ammonia addition, tetraethoxysilane in ethanol can be added in a closed system while stirring; optionally sonication may be applied. The suspension thus obtained can be filtered, washed, and dried.

The term "comprising" may in an embodiment refer to "consisting of" but may in another embodiment also refer to "containing at least the defined species and optionally one or more other species". The phrase "selected from the group consisting of trivalent" may refer in an embodiment to a single species selected from the group, but may in another embodiment also refer to one or more species selected from that group. Hence, sometimes the phrase "one or more selected from the group consisting of" is also applied. Therefore, phrases like "M selected from the group consisting of Ca, Sr, and Ba" may indicate one or more M (species) selected from the group consisting of Ca, Sr, and Ba. Therefore, such phrase also relate to combinations of two or more (where applicable).

Assuming ES to be samarium and europium (and optionally also (divalent) ytterbium), the value for x is still as herein indicated, but is the summation of the individual species. Likewise, this applies to all other elementary species indicated in the formula.

Divalent and trivalent samarium and/or divalent and trivalent europium may be present depending upon e.g. the (reducing) conditions during synthesis. As luminescent ions preferably RE and ES consist of (a) $Eu^{2+}$ (i.e. no RE, and no Sm) or (b) $Ce^{3+}$ (i.e. no ES, and no other RE) or (c) $Eu^{2+}$ and $Ce^{3+}$ (i.e. no Sm and no other RE). Hence, in embodiment (a), the molar ratio between the sum of the other all optional ES and RE on the one hand, and Eu on the other hand $((Sm(II)+RE)/Eu)<0.1$, especially <0.01, even more <0.0001; in embodiment (b), the molar ratio between the sum of the other all optional ES and RE on the one hand, and Ce on the other hand $((ES+RE)/Ce)<0.1$, especially <0.01, even more <0.0001; and in embodiment (b), the molar ratio between the sum of the other all optional ES and RE on the one hand, and Eu(II) and Ce on the other hand $((ES+RE)/(Ce+Eu(II))<0.1$, especially <0.01, even more <0.0001. Would also Yb(II) be available, $((Sm(II)+RE)/Eu)$ may be redefined as $((Sm(II)+Yb(II)+RE)/Eu)$, with $((Sm(II)+Yb(II)+RE)/Eu))<0.1$, especially <0.01, even more <0.0001.

Especially, as divalent luminescent species only one or more of Sm and Eu are chosen, especially substantially only Eu.

In another embodiment, as RE Ce and Pr are applied (especially in the absence of Sm and Eu); Pr may provide a(n additional) red luminescence. Trivalent cerium may be used to provide a yellow and/or green emitter, and/or to sensitize divalent europium (in the case both Ce and Eu are present). The species ES and RE are herein also indicated as dopants.

When ES is available and RE is available, in an embodiment y/x is preferably <0.1, especially < 0.01, in case RE≠Ce. This implies that when divalent Eu and/or Sm are applied, optional trivalent lanthanides RE are present in a molar amount that is less than 10% of the molar amount of Eu and/or Sm, respectively, in case where the optional trivalent lanthanide is not cerium. In a specific embodiment, x>0, and y=0; e.g. ES is substantially exclusively europium, like as dopant divalent europium is present, and all other potentially luminescent dopants are not available, or available in molar amounts less than 0.01 % of the molar amount of divalent europium.

In a specific embodiment, the phosphor may in addition or alternative to the luminescent rare earth ions (RE) (also) include non-luminescent rare earth ions. For the sake of understanding, this is not included in the basic formula, but in an alternative embodiment, the phosphor of formula (I) could also be rewritten as a phosphor having the formula $M_{1-x-y-z-z2}Z_zA_aB_bC_cD_dE_eN_{6-n}O_n:ES_x,RE_y,NRE_{z2}$ (formula II), with M selected from the group consisting of Ca, Sr, and Ba; Z selected from the group consisting of monovalent Na, K, and Rb; B selected from the group consisting of divalent Mg, Mn, Zn, and Cd; C selected from the group consisting of trivalent B, Al and Ga; D selected from the group consisting of tetravalent Si, Ge, Ti, and Hf; A selected from the group consisting of monovalent Li, and Cu; E selected for the group consisting of P, V, Nb, and Ta; ES selected from the group consisting of divalent Eu, Sm and Yb, especially selected group consisting of divalent Eu and Sm; RE selected from the group consisting of trivalent Ce, Pr, Nd, Sm, Eu, Gd, Tb, Dy, Ho, Er, and Tm; NRE is selected from the group consisting of Sc (scandium), La (lanthanum), and Lu (lutetium); $0 \leq x \leq 0.2$; $0 \leq y \leq 0.2$; $0 \leq z2 \leq 0.2$; $0 \leq x+y \leq 0.4$; $0 \leq z < 1$; $x + y + z < 1$; $x + y + z + z2 < 1$; $0 < y+z \leq 0.2$; $0 \leq n \leq 0.75$; $0 \leq a \leq 2$ (such as $0 \leq b \leq 0.5$); $0 \leq b \leq 2$; $0 \leq c \leq 4$; $0 \leq d \leq 4$; $0 \leq e \leq 4$; $a + b = 2$; $c + d + e = 4$; and $a + 2b + 3c + 4d + 5e + y - z = 16 - n$.

In a specific embodiment, the phosphor with formula I, for instance for application in the lighting unit, complies (further) with: M = selected from the group consisting of Ca, Sr, and Ba; Z = Na or z=0; B = Mg or a=0; C = selected from the group consisting of trivalent Al and Ga; D = selected from the group consisting of tetravalent Si and Ge; A = Li or d=0; e=0; ES = Eu; RE = Ce; wherein x/y<0.1 or wherein y/x<0.1. The other conditions as indicated above, may also apply.

The conditions wherein x/y<0.1 or wherein y/x<0.1 indicate that either RE = Ce is predominantly present as luminescent species or ES = Eu is predominantly present as luminescent species. Note that these embodiments may also include the variants wherein x=0 (only Ce) or y=0 (only Eu), respectively. Conditions like "Na or z=0" indicate that Z is either Na, or there is no Z element (Na, K, and Rb). Likewise, the condition "e=0" indicates that no E element (P, V, Nb, and Ta) is available. Impurities, see elsewhere, may however be present.

Especially good phosphors may be obtained with B comprising Mg or with b=0. Further, C may especially comprise one or more of Al and Ga. In yet a further specific embodiment, D may comprise tetravalent Si; in this way, most efficient phosphors may be obtained. Further, especially ES comprises trivalent Ce and/or divalent Eu, especially substantially only divalent Eu (and no other ES or RE). In yet a further embodiment, RE is selected from the group consisting of trivalent Ce, Pr, Sm, Gd, Tb, and Dy. In a preferred embodiment, $0 < x \leq 0.2$; in other words, at least divalent Sm and/or Eu are present, especially substantially only divalent Eu. In a further embodiment, y (and z) is (are) (substantially) zero.

Hence, especially good phosphors may be obtained with C = selected from the group consisting of Al and Ga, D = tetravalent Si, ES = divalent Eu, RE = selected from the group consisting of trivalent Ce, Pr, Sm, Gd, Tb, and Dy, and $0 < x \leq 0.2$. Even more especially, M is selected from the group consisting of Ba and Sr, C comprises (especially consists of) Al, D comprises (especially consists of) Si, ES comprises (especially consists of) Eu, and wherein $y/x < 0.1$, especially <0.01, and with preferably $n \leq 0.1$, especially <0.01. Even more especially, $y=0$.

Hence, in a specific embodiment, the phosphor has the formula M(Ba and/or Sr)$_{1-x-y}$Li$_a$Al$_c$Si$_d$N$_{6-n}$O$_n$:ES$_x$,RE$_y$ (I), with ES = selected from the group consisting of divalent Eu (europium) or Sm (samarium) or Yb (ytterbium); RE = selected from the group consisting of trivalent Ce (cerium), Pr (praseodymium), Nd (neodymium), Sm (samarium), Eu (europium), Gd (gadolinium), Tb (terbium), Dy (dysprosium), Ho (holmium), Er (erbium), and Tm (thulium), wherein $y/x < 0.1$, especially <0.01, and $n \leq 0.1$, especially <0.01, even more especially <0.001, yet even more especially <0.0001. Hence, in this embodiment, substantially samarium and or europium containing phosphors are described. For instance, when divalent Eu is present, with $x=0.05$, and for instance y1 for Pr may be 0.001, and y2 for Tb may be 0.001, leading to an $y=y1+y2=0.002$. In such instance, $y/x = 0.04$. Even more especially, $y=0$. However, as indicated elsewhere when Eu and Ce are applied, the ratio $y/x$ may be larger than 0.1.

The condition $0 < x+y \leq 0.4$ indicates that M may be substituted with in total up to 40% of ES and/or RE. The condition "$0 < x+y \leq 0.4$" in combination with x and y being between 0 and 0.2 indicates that at least one of ES and RE are present. Not necessarily both types are present. As indicated above, both ES and RE may each individually refer to one or more subspecies, such as ES referring to one or more of Sm and Eu, and RE referring to one or more of Ce, Pr, Nd, Sm, Eu, Gd, Tb, Dy, Ho, Er, and Tm.

Especially, when europium is applied as divalent luminescent species or dopant, the molar ratio between samarium and europium (Sm/Eu) is <0.1, especially < 0.01, especially <0.001.

The same applies when europium in combination with ytterbium would be applied. When europium is applied as divalent luminescent species or dopant, the molar ratio between ytterbium and europium (Yb/Eu) is <0.1, especially < 0.01, especially <0.001. Would all three together be applied, then the same molar ratios might apply, i.e. ((Sm+Yb)/Eu) is <0.1, especially < 0.01, especially <0.001.

Especially, x is in the range of 0.001-0.2 (i.e. $0.001 \leq x \leq 0.2$), like 0.002-0.2, such as 0.005-0.1, especially 0.005-0.08. Especially in the case of divalent Europium in the herein described systems, the molar percentage may be in the range of 0.1-5 % ($0.001 \leq x \leq 0.05$), such as 0.2-5%, like 0.5-2%. For other luminescent ions, x may (but is not necessarily) in embodiments be equal to or larger than 1% (x equal to or larger than 0.01).

In a specific embodiment, the phosphor is selected from the group consisting of Ba$_{0.96}$Li$_{1.6}$Mg$_{0.4}$Al$_{2.4}$Si$_{1.6}$N$_6$:Eu$_{0.04}$, Ba$_{0.99}$Li$_2$Al$_2$Si$_2$N$_6$:Eu$_{0.01}$, Ba$_{0.99}$Li$_{1.8}$Mg$_{0.2}$Al$_{2.2}$Si$_{1.8}$N$_6$:Eu$_{0.01}$, Ba$_{0.89}$Sr$_{0.1}$Li$_2$Al$_2$Si$_2$N$_6$:Eu$_{0.01}$, Ba$_{0.99}$Li$_{1.95}$Mg$_{0.05}$Al$_{2.05}$Si$_{1.95}$N$_6$:Eu$_{0.01}$, and Ba$_{0.98}$Li$_{1.8}$Mg$_{0.2}$Al$_{2.2}$Si$_{1.8}$N$_6$:Eu$_{0.02}$.

As also indicated herein, the notation "(Ba,Sr)", and similar notations with other elements, indicates that the M-positions are occupied with Ba and/or Sr cations (or other elements, respectively).

In a further specific embodiment, the phosphor is selected from the group consisting of M$_{1-x}$Li$_{2-q}$Mg$_q$Al$_{2+q+n}$Si$_{2-q-n}$N$_{6-n}$O$_n$:Eu$_x$, with especially $n \leq 0.05$, even more especially $n = 0$, and with especially $0 \leq q \leq 0.4$, even more especially $0 \leq q \leq 0.25$, and with especially M comprising Ba, with optionally M consisting of Ba with a replacement of Ba by Sr of 15 mol% or less. Especially, these phosphors may be phosphors having good luminescent properties, amongst others in terms of spectral position and distribution of the luminescence.

Of especial interest are phosphors wherein the phosphor complies with $0 \leq x \leq 0.2$, $y/x < 0.1$, M comprises at least Ba, $z \leq 0.1$, $b \leq 0.4$, C comprises at least Al, A comprises at least Li, $e \leq 0.4$, $n \leq 0.1$, and wherein ES at least comprises Eu.

Especially, $y+z \leq 0.1$. Further, especially $x+y+z \leq 0.2$. Further, especially b is close to 0 or zero. Further, especially a is about 2. Further, especially d is about 2. Further, especially e is close to 0 or zero. Further, especially n is close to 0 or zero. Further, especially y is close to 0 or zero.

In yet a further embodiment, RE comprises Ce, and $x/y < 0.1$, especially <0.01, even more especially <0.001, and $n \leq 0.1$. Hence, in this embodiment, RE comprises, or especially consists of cerium. This implies that when trivalent Ce is applied (as RE), optional divalent lanthanides SE are present in a molar amount that is less than 10% of the molar amount of Ce, respectively. For instance, when Ce is present, with $y=0.05$, for instance x1 for (divalent) Sm may be 0.001, and x2 for (divalent) Eu may be 0.001, leading to an $x=x1+x2=0.002$. In such instance, $x/y = 0.04$. Even more especially, $x=0$.

Incorporation of trivalent RE, such as Ce$^{3+}$, is especially done via charge compensation in the cationic lattice (see condition $a + 2b + 3c + 4d + 5e + y - z = 16 - n$ with y being the trivalent rare earth element fraction). In practice, to produce e.g. BaLi$_2$Al$_2$Si$_2$N$_6$:Ce, and similar systems, the formula would be Ba$_{1-x}$Ce$_x$Li$_2$Al$_{2+x}$Si$_{2-x}$N$_6$. In other words, a trivalent RE cation can be introduced on the divalent M site (and replace M) by e.g. simultaneously substituting an appropriate amount of tetravalent cations of the D type by trivalent cations of the C type.

The incorporation of oxygen via starting materials or during processing of the claimed composition can be compensated by adjustment of the host lattice cation composition as defined in above formula(s). Preferably, n is small, n < 0.1, since it was found that higher O concentrations may lead to samples with reduced stability. Even more especially, n=0.

As indicated above, RE elements may be incorporated in the lattices to increase stability or to modify the emission characteristics. Incorporation of RE typically lead to a blue shift of the Eu(II) emission bands. Ce(III) incorporation may lead to emission in the violet to blue spectral range. Codoping of the Eu(II) doped compounds with Ce(III) may be used to increase the absorption in the near-UV spectral range with Ce(III) acting as a sensitizer for the Eu(II) emission (see also above).

Referring to divalent europium: because only one lattice site may be present for $Eu^{2+}$ incorporation, the emission bands of the claimed phosphors are significantly narrower than state of the art phosphors like YAG:Ce and other related yellow-green emitting garnet phosphors which is advantageous in lighting applications since narrower emission bands typically enable better tuning of the overall spectral shape (of the applied phosphor mixture) for maximum efficiency. In case of green-emitting phosphors, decreasing half-widths enable more saturated colors as typically required in display applications.

Hence, in an embodiment, no Ge is present, and B is only Mg or b=0.

A non-exhaustive overview of systems that were made, including some optical parameters are indicated in below table 2:

| Ex. | Composition | x | y | LE (lm/W) | $\lambda_{max}$ (nm) | FWHM (nm) | $QE_{rel}$ (%) |
|---|---|---|---|---|---|---|---|
| 1 | $Ba_{0.96}Li_{1.6}Mg_{0.4}Al_{2.4}Si_{1.6}N_6:Eu_{0.04}$ | 0.443 | 0.543 | 516 | 562 | 79 | n/a |
| 2 | $Ba_{0.99}Li_2Al_2Si_2N_6:Eu_{0.01}$ | 0.329 | 0.627 | 508 | 535 | 61 | 100.0 |
| 2b | | 0.327 | 0.630 | 513 | 535 | 60 | 104.5 |
| 3 | $Ba_{0.99}Li_{1.8}Mg_{0.2}Al_{2.2}Si_{1.8}N_6:Eu_{0.01}$ | 0.331 | 0.628 | 523 | 538 | 63 | 92.7 |
| 3b | | 0.330 | 0.629 | 524 | 538 | 62 | 97.2 |
| 4 | $Ba_{0.99}Li_{1.8}Mg_{0.2}Al_{2.2}Si_{1.8}N_6:Eu_{0.01}$ | 0.340 | 0.624 | 532 | 540 | 63 | 103.0 |
| 4b | | 0.339 | 0.625 | 538 | 540 | 63 | 104.3 |
| 5 | $Ba_{0.89}Sr_{0.1}Li_2Al_2Si_2N_6:Eu_{0.01}$ | 0.340 | 0.613 | 481 | 533 | 66 | 66.6 |
| 6 | $Ba_{0.99}Li_2Al_2Si_2N_6:Eu_{0.01}$ | 0.346 | 0.614 | 490 | 535 | 62 | 102.8 |
| 7 | $Ba_{0.99}Li_{1.95}Mg_{0.05}Al_{2.05}Si_{1.95}N_6:Eu_{0.01}$ | 0.339 | 0.619 | 497 | 535 | 61 | 95.5 |
| 8 | $Ba_{0.98}Li_{1.8}Mg_{0.2}Al_{2.2}Si_{1.8}N_6:Eu_{0.02}$ | 0.362 | 0.611 | 535 | 544 | 64 | 93.9 |

Hence, especially the invention provides a phosphor having the chemical formula $M_{1-x-y-z}Z_zA_aB_bC_cD_dE_eN_{6-n}O_n:ES_x,RE_y$, wherein M comprises Ba and/or Sr, especially Ba, z≈0, especially z=0, A comprises Li, a is in the range of 1.7-2, B may be present and then comprise Mg, especially b is in the range of 0-0.3, C comprises Al, c is in the range of 1.7-2.5, especially in the range of 1.8-2.4, D comprises Si, d is in the range of 1.4-2.2, especially in the range of 1.5-2.1, E comprises P or is absent, especially e≈0, especially e=0, ES comprises $Eu^{2+}$, x is in the range of 0.001-0.1, especially x is in the range of 0.001-0.05, and RE comprises Ce and/or any one of the other indicated trivalent lanthanides, but especially y is in the range of 0-0.02, especially y≈0, even more especially y=0.

The term light source may in principle relate to any light source known in the art, but may especially refer to a LED-based light source, herein further indicated as LED. The description below will - for the sake of understanding - only address LED-based light sources. The light source is configured to provide UV and/or blue light. In a preferred embodiment, the light emitting diode is configured to generate LED light with a blue component. In other words, the light source comprises a blue LED. Hence, in an embodiment, the light source is configured to generate blue light. Especially, the LED is a solid state LED.

In yet another embodiment, the light emitting diode is configured to generate LED light with a UV component. In other words, the light source comprises a UV LED. When a UV light source is applied and blue or white light is desired, as blue component, for instance the well-known materials $BaMgAl_{10}O_{17}:Eu^{2+}$ or $(Sr,Ba,Ca)_5(PO_4)_3Cl:Eu^{2+}$ may be applied. However, also other luminescent materials that are able to convert UV light into blue light may alternatively or additionally be applied.

Preferably, the light source is a light source that during operation emits at least light at a wavelength selected from the range of 200-490 nm, especially a light source that during operation emits at least light at wavelength selected from the range of 400-490 nm, even more especially in the range of 360-460 nm. This light may partially be used by the luminescent material(s) (see below). In a specific embodiment, the light source comprises a solid state LED light source (such as a LED or laser diode).

The term "light source" may also relate to a plurality of light sources, such as 2-20 (solid state) LED light sources. Hence, the term LED may also refer to a plurality of LEDs. Hence, in a specific embodiment, the light source is configured to generate blue light.

The term white light herein, is known to the person skilled in the art. It especially relates to light having a correlated color temperature (CCT) between about 2000 and 20000 K, especially 2700-20000 K, for general lighting especially in the range of about 2700 K and 6500 K, and for backlighting purposes especially in the range of about 7000 K and 20000 K, and especially within about 15 SDCM (standard deviation of color matching) from the BBL (black body locus), especially within about 10 SDCM from the BBL, even more especially within about 5 SDCM from the BBL.

In an embodiment, the light source may also provide light source light having a correlated color temperature (CCT) between about 5000 and 20000 K, e.g. direct phosphor converted LEDs (blue light emitting diode with thin layer of phosphor for e.g. obtaining of 10000 K). Hence, in a specific embodiment the light source is configured to provide light source light with a correlated color temperature in the range of 5000-20000 K, even more especially in the range of 6000-20000 K, such as 8000-20000 K. An advantage of the relative high color temperature may be that there may be a relative high blue component in the light source light.

The terms "violet light" or "violet emission" especially relates to light having a wavelength in the range of about 380-440 nm. The terms "blue light" or "blue emission" especially relates to light having a wavelength in the range of about 440-490 nm (including some violet and cyan hues). The terms "green light" or "green emission" especially relate to light having a wavelength in the range of about 490-560 nm. The terms "yellow light" or "yellow emission" especially relate to light having a wavelength in the range of about 540-570 nm. The terms "orange light" or "orange emission" especially relate to light having a wavelength in the range of about 570-600 nm. The terms "red light" or "red emission" especially relate to light having a wavelength in the range of about 600-750 nm. The term "pink light" or "pink emission" refers to light having a blue and a red component. The terms "visible", "visible light" or "visible emission" refer to light having a wavelength in the range of about 380-750 nm.

The luminescent material comprises one or more phosphors as described herein, and optionally one or more further phosphors selected from the group consisting of divalent europium containing nitride luminescent material or a divalent europium containing oxonitride luminescent material. The luminescent material may in an embodiment further comprise one or more materials selected from the group consisting of $(Ba,Sr,Ca)S:Eu$, $(Mg,Sr,Ca)AlSiN_3:Eu$ and $(Ba,Sr,Ca)_2Si_5N_8:Eu$. In these compounds, europium (Eu) is substantially or only divalent, and replaces one or more of the indicated divalent cations. In general, Eu will not be present in amounts larger than 10% of the cation, especially in the range of about 0.5-10%, more especially in the range of about 0.5-5% relative to the cation(s) it replaces. The term ":Eu" or ":Eu²⁺", indicates that part of the metal ions is replaced by Eu (in these examples by $Eu^{2+}$). For instance, assuming 2% Eu in $CaAlSiN_3$:Eu, the correct formula could be $(Ca_{0.98}Eu_{0.02})AlSiN_3$. Divalent europium will in general replace divalent cations, such as the above divalent alkaline earth cations, especially Ca, Sr or Ba. The material $(Ba,Sr,Ca)S:Eu$ can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Further, the material $(Ba,Sr,Ca)_2Si_5N_8:Eu$ can also be indicated as $M_2Si_5N_8:Eu$, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50-100%, especially 50-90% Ba and 50-0%, especially 50-10% Sr, such as $Ba_{1.5}Sr_{0.5}Si_5N_8:Eu$, (i.e. 75 % Ba; 25% Sr). Here, Eu is introduced and replaces at least part of M i.e. one or more of Ba, Sr, and Ca). Likewise, the material $(Ba,Sr,Ca)AlSiN_3:Eu$ can also be indicated as $MAlSiN_3:Eu$ wherein M is one or more elements selected from the group consisting of barium $(Ba)_5$ strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Preferably, in an embodiment the first luminescent material comprises $(Ca,Sr,Mg)AlSiN_3:Eu$, preferably $CaAlSiN_3:Eu$. Further, in another embodiment, which may be combined with the former, the first luminescent material comprises $(Ca,Sr,Ba)_2Si_5N_8:Eu$, preferably $(Sr,Ba)_2Si_5N_8:Eu$. The terms "(Ca,Sr,Ba)" indicate that the corresponding cation may be occupied by calcium, strontium or barium. It also indicates that in such material corresponding cation sites may be occupied with cations selected from the group consisting of calcium, strontium and barium. Thus, the material may for instance comprise calcium and strontium, or only strontium, etc.

Hence, in an embodiment the luminescent material may further comprise $M_2Si_5N_8:Eu^{2+}$, wherein M is selected from the group consisting of Ca, Sr and Ba, even more especially wherein M is selected from the group consisting of Sr and Ba. In yet another embodiment, which may be combined with the former, the luminescent material may further comprise $MSiAlN_3:Eu^{2+}$, wherein M is selected from the group consisting of Ca, Sr and Ba, even more especially wherein M is selected from the group consisting of Sr and Ba.

The luminescent material may also comprise one or more phosphors selected from the group consisting of a trivalent cerium containing garnet and a trivalent cerium containing oxonitride.

The oxonitride materials are in the art often also indicated as oxynitride materials.

Especially, the luminescent material may further comprise a $M_3A_5O_{12}$:$Ce^{3+}$ luminescent material, wherein M is selected from the group consisting of Sc, Y, Tb, Gd, and Lu, wherein A is selected from the group consisting of Al and Ga. Preferably, M at least comprises one or more of Y and Lu, and wherein A at least comprises Al. These types of materials may give highest efficiencies. In a specific embodiment, the second luminescent material comprises at least two luminescent materials of the type of $M_3A_5O_{12}$:$Ce^{3+}$, wherein M is selected from the group consisting of Y and Lu, wherein A is selected from the group consisting of Al, and wherein the ratio Y:Lu differ for the at least two luminescent materials. For instance, one of them may be purely based on Y, such as $Y_3Al_5O_{12}$:$Ce^{3+}$, and one of them may be a Y,Lu based system, such as $(Y_{0.5}Lu_{0.5})_3Al_5O_{12}$:$Ce^{3+}$. Embodiments of garnets especially include $M_3A_5O_{12}$ garnets, wherein M comprises at least yttrium or lutetium and wherein A comprises at least aluminum. Such garnet may be doped with cerium (Ce), with praseodymium (Pr) or a combination of cerium and praseodymium; especially however with Ce. Especially, A comprises aluminum (Al), however, A may also partly comprise gallium (Ga) and/or scandium (Sc) and/or indium (In), especially up to about 20% of Al, more especially up to about 10 % of Al (i.e. the A ions essentially consist of 90 or more mole % of Al and 10 or less mole % of one or more of Ga, Sc and In); A may especially comprise up to about 10% gallium. In another variant, A and O may at least partly be replaced by Si and N. The element M may especially be selected from the group consisting of yttrium (Y), gadolinium (Gd), terbium (Tb) and lutetium (Lu). Further, Gd and/or Tb are especially only present up to an amount of about 20% of M. In a specific embodiment, the garnet luminescent material comprises $(Y_{1-x}Lu_x)_3Al_5O_{12}$:Ce, wherein x is equal to or larger than 0 and equal to or smaller than 1. The terms ":Ce" or ":$Ce^{3+}$" (or similar terms), indicate that part of the metal ions (i.e. in the garnets: part of the "M" ions) in the luminescent material is replaced by Ce (or another luminescent species when the term(s) would indicate that, like ":Yb"). For instance, assuming $(Y_{1-x}Lu_x)_3Al_5O_{12}$:Ce, part of Y and/or Lu is replaced by Ce. This notation is known to the person skilled in the art. Ce will replace M in general for not more than 10%; in general, the Ce concentration will be in the range of 0.1-4%, especially 0.1-2% (relative to M). Assuming 1% Ce and 10% Y, the full correct formula could be $(Y_{0.1}Lu_{0.89}Ce_{0.01})_3Al_5O_{12}$. Ce in garnets is substantially or only in the trivalent state, as known to the person skilled in the art.

Therefore, the luminescent material may in an embodiment further comprise one or more other phosphors selected from the group consisting of a divalent europium containing nitride luminescent material, a divalent europium containing oxonitride luminescent material, a trivalent cerium containing garnet and a trivalent cerium containing oxonitride.

As will be clear to the person skilled in the art, also combinations of phosphors may be applied. Further, as will be clear to the person skilled in the art, optimization of the luminescent material(s) (or phosphors) with respect to one or more of constituting elements, activator concentration, particle size, etc. or optimization with respect to luminescent material combination(s), may be applied to optimize the illumination device.

The light source may be configured in a chamber, with reflective wall(s) (such as coated with a reflective material like $TiO_2$), and a transparent window. In an embodiment, the window is the light conversion layer. In yet a further embodiment, the window comprises the light conversion layer. This layer may be arranged upstream of the window or downstream of the window. In yet a further embodiment, light conversion layers are applied at both sides of the window.

The terms "upstream" and "downstream" relate to an arrangement of items or features relative to the propagation of the light from a light generating means (here the light source), wherein relative to a first position within a beam of light from the light generating means, a second position in the beam of light closer to the light generating means is "upstream", and a third position within the beam of light further away from the light generating means is "downstream".

The luminescent material is configured to convert at least part of the light source light. In other words, one may say that the light source is radiationally coupled to the luminescent material. When the light source comprises a substantially UV light emitting light source, the luminescent material may be configured to convert substantially all light source light that impinges on the luminescent material. In case the light source is configure to generate blue light, the luminescent material may partly convert the light source light. Dependent upon the configuration, a part of the remaining light source light may be transmitted through a layer comprising the luminescent material.

Here, a number of applications of the invention are indicated: office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, and green house lighting systems.

As indicated above, the lighting unit may be used as backlighting unit in an LCD display device. Hence, in a further aspect, the invention provides also a LCD display device comprising the lighting unit as defined herein, configured as backlighting unit.

In another further aspect the invention provides a luminaire comprising at least one lighting unit as defined herein.

The term "substantially" herein, such as in "substantially all emission" or in "substantially consists", will be understood by the person skilled in the art. The term "substantially" may also include embodiments with "entirely", "completely", "all", etc. Hence, in embodiments the adjective substantially may also be removed. Where applicable, the term "substantially" may also relate to 90% or higher, such as 95% or higher, especially 99% or higher, even more especially 99.5% or higher, including 100%. The term "comprise" includes also embodiments wherein the term "comprises" means "consists of". The term "comprising" may in an embodiment refer to "consisting of" but may in another embodiment also refer to "containing at least the defined species and optionally one or more other species". The term "and/or" especially relates to one or more of the items mentioned before and after "and/or". For instance, a phrase "item 1 and/or item 2" and similar phrases may relate to one or more of item 1 and item 2.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices herein are amongst others described during operation. As will be clear to the person skilled in the art, the invention is not limited to methods of operation or devices in operation.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

The invention further applies to a device comprising one or more of the characterizing features described in the description and/or shown in the attached drawings. The invention further pertains to a method or process comprising one or more of the characterizing features described in the description and/or shown in the attached drawings.

The various aspects discussed in this patent can be combined in order to provide additional advantages. Furthermore, some of the features can form the basis for one or more divisional applications.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figs. 1a-1d schematically depict some embodiments of the lighting unit; the drawings are not necessarily on scale;
Figs. 2a-2b show some excitation & emission spectra of some of the materials prepared;
Figs. 3a-3c show some crystallographic aspects and XRD data (of some of the materials prepared).

DETAILED DESCRIPTION OF THE EMBODIMENTS

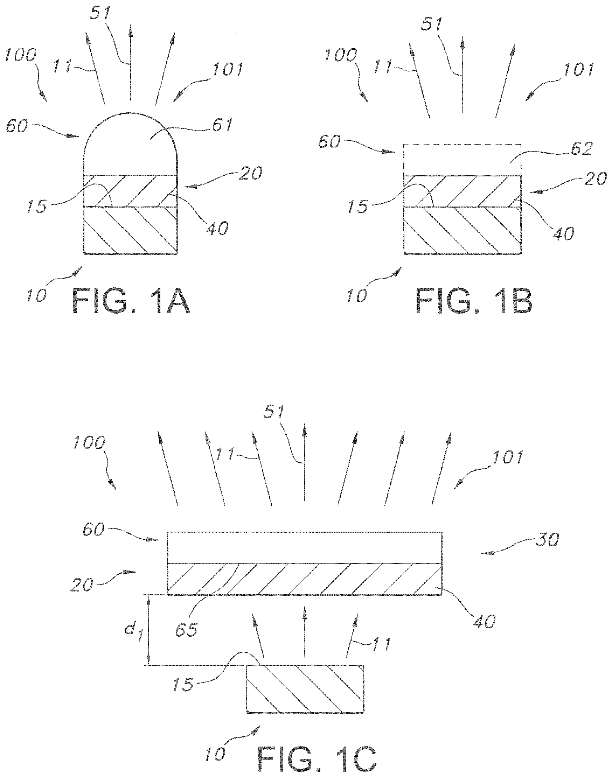

Fig. 1a schematically depicts an embodiment of the lighting unit, indicated with reference 100, of the invention. The lighting unit comprises a light source 10, which is in this schematic drawing a LED (light emitting diode). In this embodiment, on top of the light source 10, here on the (light exit) surface 15, thus downstream of the light source 10, a luminescent material 20 is provided. This luminescent material 20 comprises phosphor as described herein, indicated with reference 40. By way of example, the lighting unit 100 further comprises, for instance for light extraction properties, a (transmissive) dome 61. This is an embodiment of a transmissive optical element 60, which is in this embodiment arranged downstream of the light source 10 and also downstream of the light conversion layer 20. The light source 10 provides light source light 11 (not indicated in the drawing), which is at least partly converted by the light conversion layer 20, at least by phosphor 40, into luminescent material light 51. The light emanating from the lighting unit is indicated with reference 101, and contains at least this luminescent material light 51, but optionally, dependent upon the absorption of luminescent material 50 also light source light 11.

Fig. 1b schematically depicts another embodiment, without dome, but with an optional coating 62. This coating 62 is a further example of a transmissive optical element 60. Note that the coating 62 may in an embodiment be one or more of a polymeric layer, a silicone layer, or an epoxy layer. Alternatively or additionally a coating of silicon dioxide and/or silicon nitride may be applied.

In both schematically depicted embodiment of figs. 1a-1b, the luminescent material 20 is in physical contact with the light source 10, or at least its light exit surface (i.e. surface 15), such as the die of a LED. In fig. 1c, however, the luminescent material 20 is arranged remote from the light source 10. In this embodiment, the luminescent material 20 is configured upstream of a transmissive (i.e. light transmissive) support 30, such as an exit window. The surface of the support 30, to which the light conversion layer 20 is applied, is indicated with reference 65. Note that the luminescent material 20 may also be arranged downstream of the support 30, or at both sides of the support luminescent material 20 may be applied. The distance between the luminescent material 20 and the light source (especially its light exit surface 15) is indicated with reference d1, and may be in the range of 0.1 mm - 10 cm. Note that in the configuration of fig. 1c, in principle also more than one light source 10 may be applied.

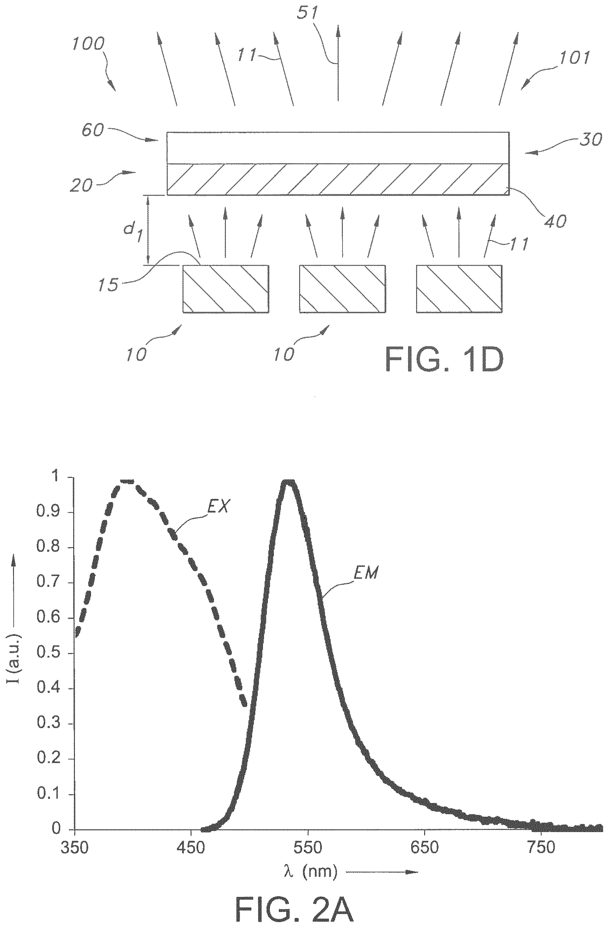

Fig. 1d is schematically the same as fig. 1c, but now with a plurality of light sources 10.

Optionally, the luminescent material is shaped into a self supporting layer, such as a ceramic material. In such instance, the transmissive optical element 60 may not be necessary, but may nevertheless be present.

EXPERIMENTAL

*Phosphor Synthesis*

Typical starting compounds for the new nitridoalumosilicate phosphor include earth alkaline metal hydrides and nitrides, $Li_3N$, $LiH$, $AlN$, $Si_3N_4$, $Eu_2O_3$, $EuCl_3$, $EuF_3$, or precursor materials made thereof and of additional compounds or metals like Li, Mg, Al, Si (e.g. $Ba_{1-x}AlSi:Eu_x$ precursor as used in Example 2 and 6).

Starting compositions may either be chosen to be stoichiometric or non-stoichiometric to compensate for selective evaporation losses (e.g. Li evaporation), which may depend on sintering conditions. Sintering is typically carried out at temperatures of 950-1250°C in nitrogen containing atmosphere ($N_2/H_2(5\%)$ or pure $N_2$). Molybdenum and silicon carbide are crucible materials of choice.

Improvements in terms of phase purity, which may results in better optical properties, can be achieved by acidic washing of as-sintered powders (e.g. washing in diluted acids) or by separation of fines that may lower the blue pump light absorption of the sample and/or increase typically unwanted light scattering within the phosphor layer. This separation can be achieved by sedimentation in suitable liquids like alcohols (e.g. iso-PrOH (iso propanol) as used in Example 2b, 3b, 6, 7, 8) or alternative size-selective separation methods.

Table 2 above gives an overview of samples of the new nitridoalumosilicate phosphor wherein x, y, LE, and $QE_{rel}$ are calculated from emission spectra of powders under 440 nm excitation. Single crystals (Example 1) were measured in a luminescence microscope with 450 nm excitation.

*Examples*

Example 1: $Ba_{0.96}Li_{1.6}Mg_{0.4}Al_{2.4}Si_{1.6}N_6:Eu_{0.04}$

Single crystals of nominal composition $BaMg_{2-a}Li_aAl_{2+a}Si_{2-a}N_6:Eu(4\%)$ were synthesized by reacting mixtures of $Ba_3Mg_3N_2F_6$, $Si(NH)_2$, $AlF_3$, $Li_3N$, Li, and $EuF_3$ in a sealed tantalum ampoule. Suitable crystals were picked for crystal structure determination by X-ray diffraction methods and photoluminescence measurements in a luminescence microscope. For a = 0.4 crystals were obtained showing yellow luminescence with peak emission at ~562nm (450nm excitation, luminescence microscope).

Example 2: $Ba_{0.99}Li_2Al_2Si_2N_6:Eu_{0.01}$

A mixture of 11.553g $Ba_{0.99}AlSi:Eu_{0.01}$, 1.394g $Li_3N$, 2.460g AlN, and 2.806g $Si_3N_4$ was fired for 2h at 1150°C in a molybdenum crucible in forming gas $N_2/H_2$ (5%). The resulting greenish yellow powder shows green luminescence with peak emission at ~534 nm (440 nm excitation).

*Pose-treatment*

A fraction of the as-sintered powder was post-treated in 0.05M acetic acid (stirring 1h at 25°C). After decantation, filtration, and washing with 0.05M acetic acid and deionized water, the powder was dried and suspended in iso-PrOH. After 3h of sedimentation, the supernatant was removed and the residual powder dried at 120°C for further measurements (Example 2b).

Figure 2a shows an emission and an excitation spectrum of as-sintered $Ba_{0.99}Li_2Al_2Si_2N_6:Eu_{0.01}$ phosphor powder (Example 2, 440 nm excitation for emission spectrum, detection at 540 nm for excitation spectrum).

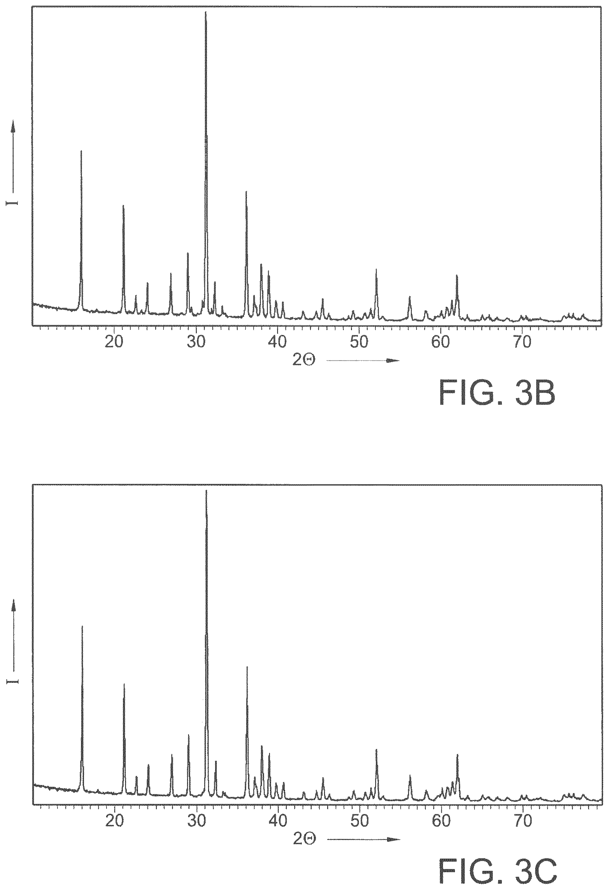

Figure 3b. X-ray diffraction powder pattern of the new nitridoalumosilicate phosphor, Example 2, as-sintered (measured with Cu-K$\alpha$ radiation), with at the x-axis 2Theta and at the $\gamma$-axis intenstity. The measured XRD pattern complies well with the predicted XRD pattern.

Figure 3c. X-ray diffraction powder pattern of the new nitridoalumosilicate phosphor, Example 2b, after washing and sedimentation (measured with Cu-K$\alpha$ radiation), with at the x-axis 2Theta and at the $\gamma$-axis intenstity. The measured XRD pattern complies well with the predicted XRD pattern.

Example 3: $Ba_{0.99}Li_{1.8}Mg_{0.2}Al_{2.2}Si_{1.8}N_6$:$Eu_{0.01}$

A mixture of 10.347g $BaH_2$, 1.567g $Li_3N$, 0.505g $Mg_3N_2$, 6.763g AlN, 6.313g $Si_3N_4$, and 0.132g $Eu_2O_3$ was fired for 2h at 700°C and 4h at 1125°Cin a molybdenum crucible in forming gas $N_2/H_2$(5%). The resulting greenish yellow powder shows green luminescence with peak emission at ~537 nm (440 nm excitation).

*Post-treatment*

A fraction of the as-sintered powder was post-treated in 0.05M acetic acid (stirring 1h at 25°C). After decantation, filtration, and washing with 0.05M acetic acid and deionized water, the powder was dried and suspended in iso-PrOH. After 3h of sedimentation, the supernatant was removed and the residual powder dried at 120°C for further measurements (Example 3b).

Figure 2b shows an emission and an excitation spectrum of as-sintered $Ba_{0.99}Li_{1.8}Mg_{0.2}Al_{2.2}Si_{1.8}N_6$:$Eu_{0.01}$ phosphor powder (Example 3, 440 nm excitation for emission spectrum, detection at 540 nm for excitation spectrum).

Example 4: $Ba_{0.99}Li_{1.8}Mg_{0.2}Al_{2.2}Si_{1.8}N_6$:$Eu_{0.01}$

A mixture of 10.347g $BaH_2$, 0.132g $Eu_2O_3$, 1.567g $Li_3N$, 0.505g $Mg_3N_2$, 6.148g AlN, and 6.313g $Si_3N_4$ was fired for 2h at 700°C and 12h at 1100°C in a molybdenum crucible in $N_2/H_2$ (5%) atmosphere. The resulting powder shows green luminescence with peak emission at ~540 nm (440 nm excitation).

*Post-treatment*

A fraction of the as-sintered powder was post-treated in 0.05M acetic acid (stirring 1h at 25°C). After decantation, filtration and washing with 0.05M acetic acid and deionized water, the powder was dried at 120°C for further measurements (Example 4b). The resulting powder shows green luminescence with peak emission at ~540nm (440nm excitation).

Example 5: $Ba_{0.89}Sr_{0.1}Li_2Al_2Si_2N_6$:$Eu_{0.01}$

A mixture of 9.301g $BaH_2$, 0.672g $SrH_2$, 0.132g $Eu_2O_3$, 1.742g $Li_3N$, 6.148g AlN, and 7.014g $Si_3N_4$ was fired for 2h at 700°C and 4h at 1175°C in a molybdenum crucible in $N_2/H_2$ (5%) atmosphere. The resulting powder shows green luminescence with peak emission at ~533 nm (440 nm excitation).

Example 6: $Ba_{0.99}Li_2Al_2Si_2N_6$:$Eu_{0.01}$

A mixture of 13.478g $Ba_{0.99}Eu_{0.01}AlSi$, 1.625g $Li_3N$, 2.869g AlN, and 3.273g $Si_3N_4$ was fired for 4h at 1150°C in a molybdenum crucible in $N_2/H_2$(5%) atmosphere. The as-sintered powder was suspended in iso-PrOH. After 3h of sedimentation, the supernatant was removed and the residual powder dried at 120°C. The resulting powder shows green luminescence with peak emission at ~535 nm (440 nm excitation).

Example 7: $Ba_{0.99}Li_{1.95}Mg_{0.05}Al_{2.05}Si_{1.95}N_6$:$Eu_{0.01}$

A mixture of 13.795g $BaH_2$, 0.258g $EuCl_3$, 2.264g $Li_3N$, 0.168g $Mg_3N_2$, 7.583g AlN, and 9.118g $Si_3N_4$ was fired for 2h at 700°C and 4h at 1100°C in a molybdenum crucible in $N_2/H_2$(5%) atmosphere. The as-sintered powder was suspended in iso-PrOH. After 3h of sedimentation, the supernatant was removed and the residual powder dried at 120°C. The resulting powder shows green luminescence with peak emission at ~535nm (440nm excitation).

Example 8: $Ba_{0.98}Li_{1.8}Mg_{0.2}Al_{2.2}Si_{1.8}N_6$:$Eu_{0.02}$

A mixture of 10.242g $BaH_2$, 0.264g $Eu_2O_3$, 1.567g $Li_3N$, 0.505g $Mg_3N_2$, 6.148g AlN, and 6.313g $Si_3N_4$ was fired for 2h at 700°C and 4h at 1150°C in a molybdenum crucible in $N_2/H_2$(5%) atmosphere. The as-sintered powder was post-treated in 0.05M acetic acid (stirring 1h at 25°C). After decantation, filtration and washing with 0.05M acetic acid and deionized water, the powder was dried at 120°C for further measurements. The resulting powder shows green luminescence with peak emission at ~544 nm (440 nm excitation).

*Crystallographic Data*

From single crystal data (Example 1) the tetragonal space group P 4/n c c (No. 130) has been determined (tetragonal system, a=b≠c, α=β=γ=90°). Lattice parameters and cell volumes are summarized in Table 3 below. All data except for Example 1 have been obtained from Rietveld refinements of X-ray diffraction powder patterns.

Table 3. Overview of crystallographic data of the new nitridoalumosilicate phosphor; space group and crystal structure are based on data obtained from single crystals:

| Example | Composition | a/Å | c/Å | c/a | V/Å³ |
|---|---|---|---|---|---|
| 1 | $Ba_{0.96}Li_{1.6}Mg_{0.4}Al_{2.4}Si_{1.6}N_6:Eu_{0.04}$ | 7.892 | 9.995 | 1.266 | 622.525 |
| 2 | $Ba_{0.99}Li_2Al_2Si_2N_6:Eu_{0.01}$ | 7.828 | 9.899 | 1.265 | 606.587 |
| 2b | | 7.830 | 9.901 | 1.264 | 607.019 |
| 3 | $Ba_{0.99}Li_{1.8}Mg_{0.2}Al_{2.2}Si_{1.8}N_6:Eu_{0.01}$ | 7.856 | 9.917 | 1.262 | 612.045 |
| 3b | | 7.860 | 9.921 | 1.262 | 612.915 |
| 4 | $Ba_{0.99}Li_{1.8}Mg_{0.2}Al_{2.2}Si_{1.8}N_6:Eu_{0.01}$ | 7.857 | 9.930 | 1.264 | 613.003 |
| 4b | | 7.857 | 9.930 | 1.264 | 613.003 |
| 5 | $Ba_{0.89}Sr_{0.1}Li_2Al_2Si_2N_6:Eu_{0.01}$ | 7.820 | 9.887 | 1.264 | 604.614 |
| 6 | $Ba_{0.99}Li_2Al_2Si_2N_6:Eu_{0.01}$ | 7.825 | 9.900 | 1.265 | 606.183 |
| 7 | $Ba_{0.99}Li_{1.95}Mg_{0.05}Al_{2.05}Si_{1.95}N_6:Eu_{0.01}$ | 7.829 | 9.905 | 1.265 | 607.110 |
| 8 | $Ba_{0.98}Li_{1.8}Mg_{0.2}Al_{2.2}Si_{1.8}N_6:Eu_{0.02}$ | 7.858 | 9.923 | 1.263 | 612.727 |

Figure 3a shows the crystal structure of the new nitridoalumosilicate phosphor described in the present invention; A and B type cations are tetrahedrally coordinated on one set of crystallographically equivalent lattice sites, C, D, and E type cations are tetrahedrally coordinated on a second set of crystallographically equivalent lattice sites. M and Z type cations are 8-fold coordinated. All XRD patterns that were made of the prepared examples, not only those displayed herein, correspond well to the calculated XRD patterns.

**Claims**

1. A lighting unit (100) comprising a light source (10), configured to generate light source light (11) and a luminescent material (20), configured to convert at least part of the light source light (11) into luminescent material light (51), wherein the light source (10) comprises a light emitting diode (LED), and wherein the luminescent material (20) comprises a phosphor (40) having the formula:

$$M_{l-x-y-z}Z_zA_aB_bC_cD_dE_eN_{6-n}O_n:ES_x,RE_y \qquad (I)$$

with

M = selected from the group consisting of divalent Ca, Sr, and Ba
Z = selected from the group consisting of monovalent Na, K, and Rb
A = selected from the group consisting of monovalent Li and Cu
B = selected from the group consisting of divalent Mg, Mn, Zn, and Cd
C = selected from the group consisting of trivalent B, Al, and Ga
D = selected from the group consisting of tetravalent Si, Ge, Ti, and Hf
E = selected from the group consisting of pentavalent P, V, Nb, and Ta
ES = selected from the group consisting of divalent Eu, Sm, and Yb
RE = selected from the group consisting of trivalent Ce, Pr, Nd, Sm, Eu, Gd, Tb, Dy, Ho, Er, and Tm

$$0 \leq x \leq 0.2; \ 0 \leq y \leq 0.2; \ 0 < x+y \leq 0.4;$$

$$0 \leq z < 1; \; x + y + z < 1;$$

$$0 \leq n \leq 0.75;$$

$$0 \leq a \leq 2; \; 0 \leq b \leq 2; 0 \leq c \leq 4; 0 \leq d \leq 4; \; 0 \leq e \leq 4;$$

$$a + b = 2; \; c + d + e = 4;$$

and

$$a + 2b + 3c + 4d + 5e + y - z = 16 - n.$$

2. The lighting unit (100) according to claim 1, wherein further one or more of the following applies (i) $z+a>0$, and (ii) $0 \leq b \leq 0.5$.

3. The lighting unit (100) according to any one of the preceding claims, wherein

   M = selected from the group consisting of Ba and Sr
   A = Li
   B = Mg
   C = selected from the group consisting of Al and Ga
   D = tetravalent Si
   ES = divalent Eu
   RE = selected from the group consisting of trivalent Ce, Pr, Sm, Gd, Tb, and Dy, wherein $0 < x \leq 0.2$, and wherein $y/x < 0.1$ and $n \leq 0.1$.

4. The lighting unit (100) according to any one of claims 1-3, wherein RE comprises Ce, and wherein $x/y < 0.1$ and $n \leq 0.1$.

5. The lighting unit (100) according to any one of the preceding claims, wherein M comprises Ba and wherein $x + y + z < 0.15$.

6. The lighting unit (100) according to any one of the preceding claims, wherein A comprises Li and wherein $a > 1.5$.

7. The lighting unit (100) according to any one of the preceding claims, wherein the phosphor of formula (I) has a tetragonal crystal symmetry with space group P 4/n c c, wherein the luminescent material (20) further comprise one or more other phosphors selected from the group consisting of a divalent europium containing nitride luminescent material, a divalent europium containing oxonitride luminescent material, a trivalent cerium containing garnet and a trivalent cerium containing oxonitride, and wherein the light source (10) is configured to generate blue light.

8. The lighting unit (100) according to any one of the preceding claims, wherein the luminescent material (20) further comprise one or more other phosphors selected from the group consisting of $Ba_{0.95}Sr_{0.05}Mg_2Ga_2N_4{:}Eu$, $BaMg_2Ga_2N_4{:}Eu$, $SrMg_3SiN_4{:}Eu$, $SrMg_2Al_2N_4{:}Eu$, $SrMg_2Ga_2N_4{:}Eu$, $BaMg_3SiN_4{:}Eu$, $CaLiAl_3N_4{:}Eu$, $SrLiAl_3N_4{:}Eu$, $CaLi_{0.5}MgAl_{2.5}N_4{:}Eu$, and $SrLi_{0.5}MgAl_{2.5}N_4{:}Eu$.

9. A phosphor having the formula:

$$M_{1-x-y-z}Z_zA_aB_bC_cD_dE_eN_{6-n}O_n{:}ES_x,RE_y \qquad (I)$$

with

   M = selected from the group consisting of divalent Ca, Sr, and Ba
   Z = selected from the group consisting of monovalent Na, K, and Rb

A = selected from the group consisting of monovalent Li, and Cu
B = selected from the group consisting of divalent Mg, Mn, Zn, and Cd
C = selected from the group consisting of trivalent B, Al, and Ga
D = selected from the group consisting of tetravalent Si, Ge, Ti, and Hf
E = selected for the group consisting of pentavalent P, V, Nb, and Ta
ES = selected from the group consisting of divalent Eu, Sm, and Yb
RE = selected from the group consisting of trivalent Ce, Pr, Nd, Sm, Eu, Gd, Tb, Dy, Ho, Er, and Tm

$$0 \leq x \leq 0.2; \ 0 \leq y \leq 0.2; \ 0 < x+y \leq 0.4;$$

$$0 \leq z < 1; \ x + y + z < 1;$$

$$0 \leq n \leq 0.75;$$

$$0 \leq a \leq 2; \ 0 \leq b \leq 2; 0 \leq c \leq 4; 0 \leq d \leq 4; \ 0 \leq e \leq 4;$$

$$a + b = 2; \ c + d + e = 4;$$

and

$$a + 2b + 3c + 4d + 5e + y - z = 16 - n.$$

10. The phosphor according to claim 9, wherein z+a>0, $0 \leq b \leq 0.5$, M comprises Ba and wherein x + y + z < 0.15, and wherein A comprises Li and wherein a > 1.5.

11. The phosphor according to any one of claims 9-10, wherein

B = Ba
C = selected from the group consisting of Al and Ga
D = tetravalent Si
ES = divalent Eu
RE = selected from the group consisting of trivalent Ce, Pr, Sm, Gd, Tb, and Dy, wherein $0 \leq b \leq 0.5$, $0 < x \leq 0.2$, and wherein y/x < 0.1 and $n \leq 0.1$.

12. The phosphor according to any one claims 9-11, wherein the phosphor comprises $M_{1-x}Li_{2-q}Mg_qAl_{2+q+n}Si_{2-q-n}N_{6-n}O_n:Eu_x$, with $n \leq 0.05$, and $0 \leq q \leq 0.4$, and with M comprising Ba.

13. The phosphor according to any one claims 9-12, wherein RE comprises Ce, and wherein x/y < 0.1 and $n \leq 0.1$.

14. The phosphor according to any one claims 9-13, wherein the phosphor comprises phosphor particles having a coating, wherein the coating comprises one or more coating selected from the group consisting of an $AlPO_4$ coating, an $Al_2O_3$ coating and a $SiO_2$ coating.

15. An LCD display device comprising the lighting unit according any one of claims 1-8 configured as backlighting unit.

16. A luminaire comprising the lighting unit according to any one of claims 1 - 8.

**Patentansprüche**

1. Beleuchtungseinheit (100), umfassend eine Lichtquelle (10), die so konfiguriert ist, dass sie ein Lichtquellenlicht (11) erzeugt, und ein lumineszierendes Material (20), das so konfiguriert ist, dass es zumindest einen Teil des Lichtquellenlichts (10) in Licht (51) lumineszierenden Materials umwandelt, wobei die Lichtquelle (10) eine lichtemittierende Diode (LED) umfasst, und wobei das lumineszierende Material (20) ein Phosphor (40) mit der Formel umfasst:

$$M_{1-x-y-z}Z_zA_aB_bC_cD_dE_eN_{6-n}O_n{:}ES_x,RE_y \qquad (I)$$

wobei

M = aus der Gruppe ausgewählt ist, bestehend aus zweiwertigem Ca, Sr und Ba
Z = aus der Gruppe ausgewählt ist, bestehend aus einwertigem Na, K und Rb
A = aus der Gruppe ausgewählt ist, bestehend aus einwertigem Li und Cu
B = aus der Gruppe ausgewählt ist, bestehend aus zweiwertigem Mg, Mn, Zn und Cd
C = aus der Gruppe ausgewählt ist, bestehend aus dreiwertigem B, Al und Ga
D = aus der Gruppe ausgewählt ist, bestehend aus vierwertigem Si, Ge, Ti und Hf
E = aus der Gruppe ausgewählt ist, bestehend aus fünfwertigem P, V, Nb und Ta
ES = aus der Gruppe ausgewählt ist, bestehend aus zweiwertigem Eu, Sm und Yb
RE = aus der Gruppe ausgewählt ist, bestehend aus dreiwertigem Ce, Pr, Nd, Sm, Eu, Gd, Tb, Dy, Ho, Er und Tm

$$0 \le x \le 0{,}2;\ 0 \le y \le 0{,}2;\ 0 \le x + y \le 0{,}4;$$

$$0 \le z \le 1;\ x + y + z < 1;$$

$$0 \le n \le 0{,}75;$$

$$0 \le a \le 2;\ 0 \le b \le 2; 0 \le c \le 4; 0 \le d \le 4;\ 0 \le e \le 4;$$

$$a + b = 2;\ c + d + e = 4;$$

und

$$a + 2b + 3c + 4d + 5e + y - z = 16 - n.$$

2. Beleuchtungseinheit (100) nach Anspruch 1, wobei des Weiteren eines oder mehreres des Folgenden von (i) $z + a > 0$ und (ii) $0 \le b \le 0{,}5$ gilt.

3. Beleuchtungseinheit (100) nach einem der vorstehenden Ansprüche, wobei:

M = aus der Gruppe ausgewählt ist, bestehend aus Ba und Sr
A = Li
B = Mg
C = aus der Gruppe ausgewählt ist, bestehend aus Al und Ga
D = vierwertiges Si
ES = zweiwertiges Eu
RE = aus der Gruppe ausgewählt ist, bestehend aus dreiwertigem Ce, Pr, Sm, Gd, Tb und Dy, wobei $0 < x \le 0{,}2$, und wobei $y\,/\,x < 0{,}1$ und $n \le 0{,}1$.

4. Beleuchtungseinheit (100) nach einem der Ansprüche 1 bis 3, wobei RE Ce umfasst und wobei $x\,/\,y < 0{,}1$ und $n \le 0{,}1$.

5. Beleuchtungseinheit (100) nach einem der vorstehenden Ansprüche, wobei M Ba umfasst und wobei $x + y + z < 0{,}15$.

6. Beleuchtungseinheit (100) nach einem der vorstehenden Ansprüche, wobei A Li umfasst und wobei a > 1,5.

7. Beleuchtungseinheit (100) nach einem der vorstehenden Ansprüche, wobei das Phosphor der Formel (I) eine tetragonale Kristallsymmetrie mit einer Raumgruppe P 4/n c c aufweist, wobei das lumineszierende Material (20) des Weiteren ein oder mehrere andere Phosphore umfasst, die aus der Gruppe ausgewählt sind, bestehend aus einem zweiwertigen europiumhaltigen lumineszierenden Nitridmaterial, einem zweiwertigen europiumhaltigen lumineszierenden Oxonitridmaterial, einem dreiwertigen ceriumhaltigen Granat und einem dreiwertigen ceriumhaltigen Oxonitrid, und wobei die Lichtquelle (10) so konfiguriert ist, dass sie blaues Licht erzeugt.

8. Beleuchtungseinheit (100) nach einem der vorstehenden Ansprüche, wobei das lumineszierende Material (20) des Weiteren ein oder mehrere andere Phosphore umfasst, die aus der Gruppe ausgewählt sind, bestehend aus $Ba_{0,95}Sr_{0,05}Mg_2Ga_2N_4$:Eu, $BaMg_2Ga_2N_4$:Eu, $SrMg_3SiN_4$:Eu, $SrMg_2Al_2N_4$:Eu, $SrMg_2Ga_2N_4$:Eu, $BaMg_3SiN_4$:Eu, $CaLiAl_3N_4$:Eu, $SrLiAl_3N_4$:Eu, $CaLi_{0,5}MgAl_{2,5}N_4$:Eu, and $SrLi_{0,5}MgAl_{2,5}N_4$:Eu.

9. Phosphor mit der Formel:

$$M_{1-x-y-z}Z_zA_aB_bC_cD_dE_eN_{6-n}O_n:ES_x,RE_y \qquad (I)$$

wobei

M = aus der Gruppe ausgewählt ist, bestehend aus zweiwertigem Ca, Sr und Ba
Z = aus der Gruppe ausgewählt ist, bestehend aus einwertigem Na, K und Rb A = aus der Gruppe ausgewählt ist, bestehend aus einwertigem Li und Cu
B = aus der Gruppe ausgewählt ist, bestehend aus zweiwertigem Mg, Mn, Zn und Cd
C = aus der Gruppe ausgewählt ist, bestehend aus dreiwertigem B, Al und Ga
D = aus der Gruppe ausgewählt ist, bestehend aus vierwertigem Si, Ge, Ti und Hf
E = aus der Gruppe ausgewählt, bestehend aus fünfwertigem P, V, Nb und Ta
ES = aus der Gruppe ausgewählt ist, bestehend aus zweiwertigem Eu, Styrolmonomer und Yb
RE = aus der Gruppe ausgewählt ist, bestehend aus dreiwertigem Ce, Pr, Nd, Sm, Eu, Gd, Tb, Dy, Ho, Er und Tm

$$0 \leq x \leq 0,2; \; 0 \leq y \leq 0,2; \; 0 \leq x + y \leq 0,4;$$

$$0 \leq z \leq 1; \; x + y + z < 1;$$

$$0 \leq n \leq 0,75;$$

$$0 \leq a \leq 2; \; 0 \leq b \leq 2; 0 \leq c \leq 4; 0 \leq d \leq 4; \; 0 \leq e \leq 4;$$

$$a + b = 2; \; c + d + e = 4;$$

und

$$a + 2b + 3c + 4d + 5e + y - z = 16 - n.$$

10. Phosphor nach Anspruch 9, wobei z + a > 0, $0 \leq b \leq 0,5$, M Ba umfasst und wobei x + y + z < 0,15 und wobei A Li umfasst und wobei a > 1,5.

11. Phosphor nach einem der Ansprüche 9 bis 10, wobei:

B = Ba

C = aus der Gruppe ausgewählt ist, bestehend aus Al und Ga

D = vierwertiges Si

ES = zweiwertiges Eu

RE = aus der Gruppe ausgewählt ist, bestehend aus dreiwertigem Ce, Pr, Sm, Gd, Tb und Dy, wobei $0 \leq b \leq 0{,}5$, $0 \leq x \leq 0{,}2$, und wobei $y / x < 0{,}1$ und $n \leq 0{,}1$.

12. Phosphor nach einem der Ansprüche 9 bis 11, wobei das Phosphor $M_{1-x}Li_{2-q}Mg_qAl_{2+q+n}Si_{2-q-n}N_{6-n}O_n:Eu_x$ umfasst, wobei $n \leq 0{,}05$ und $0 \leq q \leq 0{,}4$ und wobei M Ba umfasst.

13. Phosphor nach einem der Ansprüche 9 bis 12, wobei RE Ce umfasst und wobei $x / y < 0,1$ und $n \leq 0,1$.

14. Phosphor nach einem der Ansprüche 9 bis 13, wobei das Phosphor Phosphorpartikel mit einer Beschichtung umfasst, wobei die Beschichtung eine oder mehrere Beschichtungen umfasst, die aus der Gruppe ausgewählt sind, bestehend aus $AlPO_4$-Beschichtung, $Al_2O_2$-Beschichtung und $SiCO_2$-Beschichtung.

15. LCD-Anzeigevorrichtung, die die Beleuchtungseinheit nach einem der Ansprüche 1 bis 8 umfasst, die als Hintergrundbeleuchtungseinheit konfiguriert ist.

16. Leuchte, die die Beleuchtungseinheit nach einem der Ansprüche 1 bis 8 umfasst.

## Revendications

1. Unité d'éclairage (100) comprenant une source de lumière (10), configurée pour générer une lumière de source de lumière (11) et un matériau luminescent (20), configuré pour convertir au moins une partie de la lumière de source de lumière (11) en lumière de matériau luminescent (51), dans laquelle la source de lumière (10) comprend une diode électroluminescente (DEL), et dans laquelle le matériau luminescent (20) comprend un luminophore (40) de formule :

$$M_{1-x-y-z}Z_zA_aB_bC_cD_dE_eN_{6-n}O_n:ES_x,RE_y \qquad (I)$$

dans laquelle

M est choisi dans l'ensemble constitué par les éléments divalents Ca, Sr et Ba,

Z est choisi dans l'ensemble constitué par les éléments monovalents Na, K et Rb,

A est choisi dans l'ensemble constitué par les éléments monovalents Li et Cu,

B est choisi dans l'ensemble constitué par les éléments divalents Mg, Mn, Zn et Cd,

C est choisi dans l'ensemble constitué par les éléments trivalents B, Al et Ga,

D est choisi dans l'ensemble constitué par les éléments tétravalents Si, Ge, Ti et Hf,

E est choisi dans l'ensemble constitué par les éléments pentavalents P, V, Nb et Ta,

ES est choisi dans l'ensemble constitué par les éléments divalents Eu, Sm et Yb,

RE est choisi dans l'ensemble constitué par les éléments trivalents Ce, Pr, Nd, Sm, Eu, Gd, Tb, Dy, Ho, Er et Tm,

$$0 \leq x \leq 0{,}2 \; ; \; 0 \leq y \leq 0{,}2 \; ; \; 0 < x+y \leq 0{,}4 \; ;$$

$$0 \leq z < 1 \; ; \; x + y + z < 1 \; ;$$

$$0 \leq n \leq 0{,}75 \; ;$$

$$0 \leq a \leq 2 \; ; \; 0 \leq b \leq 2 \; ; \; 0 \leq c \leq 4 \; ; \; 0 \leq d \leq 4 \; ; \; 0 \leq e \leq 4 \; ;$$

$$a + b = 2 \; ; \; c + d + e = 4 \; ;$$

et

$$a + 2b + 3c + 4d + 5e + y - z = 16 - n.$$

2. Unité d'éclairage (100) selon la revendication 1, dans laquelle en outre une ou plusieurs des inégalités suivantes s'appliquent : ((i) z + a > 0 et (ii) $0 \leq b \leq 0,5$.

3. Unité d'éclairage (100) selon l'une quelconque des revendications précédentes, dans laquelle

M est choisi dans l'ensemble constitué par Ba et Sr,
A est Li,
B est Mg,
C est choisi dans l'ensemble constitué par Al et Ga,
D est le Si tétravalent,
ES est l'Eu divalent,
RE est choisi dans l'ensemble constitué par les éléments trivalents Ce, Pr, Sm, Gd, Tb et Dy, dans laquelle $0 < x \leq 0,2$, et dans laquelle y/x < 0,1 et $n \leq 0,1$.

4. Unité d'éclairage (100) selon l'une quelconque des revendications 1 à 3, dans laquelle RE comprend du Ce, et dans laquelle x/y < 0,1 et $n \leq 0,1$.

5. Unité d'éclairage (100) selon l'une quelconque des revendications précédentes, dans laquelle M comprend du Ba et dans laquelle x + y + z < 0,15.

6. Unité d'éclairage (100) selon l'une quelconque des revendications précédentes, dans laquelle A comprend du Li et dans laquelle a > 1,5.

7. Unité d'éclairage (100) selon l'une quelconque des revendications précédentes, dans laquelle le luminophore de formule (1) a une symétrie cristalline tétragonale avec un groupe d'espacement P 4/n c c, dans laquelle le matériau luminescent (20) comprend en outre un ou plusieurs luminophores choisis dans l'ensemble constitué par un matériau luminescent de type nitrure contenant de l'europium divalent, un matériau luminescent de type oxonitrure contenant de l'europium divalent, un grenat contenant du cérium trivalent et un oxonitrure contenant du cérium trivalent, et dans laquelle la source de lumière (10) est configurée pour générer une lumière bleue.

8. Unité d'éclairage (100) selon l'une quelconque des revendications précédentes, dans laquelle le matériau luminescent (20) comprend en outre un ou plusieurs luminophores choisis dans l'ensemble constitué par $Ba_{0,95}Sr_{0,05}Mg_2Ga_2N_4$:Eu, $BaMg_2Ga_2N_4$:Eu, $SrMg_3SiN_4$:Eu, $SrMg_2Al_2N_4$:Eu, $SrMg_2Ga_2N_4$:Eu, $BaMg_3SiN_4$:Eu, $CaLiAl_3Na$:Eu, $SrLiAl_3N_4$:Eu, $CaLi_{0,5}MgAl_{2,5}N_4$:Eu, et $SrLi_{0,5}MgAl_{2,5}N_4$:Eu.

9. Luminophore de formule :

$$M_{1-x-y-z}Z_zA_aB_bC_cD_dE_eN_{6-n}O_n:ES_x,RE_y \qquad (I)$$

dans laquelle

M est choisi dans l'ensemble constitué par les éléments divalents Ca, Sr et Ba,
Z est choisi dans l'ensemble constitué par les éléments monovalents Na, K et Rb,
A est choisi dans l'ensemble constitué par les éléments monovalents Li et Cu,
B est choisi dans l'ensemble constitué par les éléments divalents Mg, Mn, Zn et Cd,
C est choisi dans l'ensemble constitué par les éléments trivalents B, Al et Ga,
D est choisi dans l'ensemble constitué par les éléments tétravalents Si, Ge, Ti et Hf,
E est choisi dans l'ensemble constitué par les éléments pentavalents P, V, Nb et Ta,
ES est choisi dans l'ensemble constitué par les éléments divalents Eu, Sm et Yb,
RE est choisi dans l'ensemble constitué par les éléments trivalents Ce, Pr, Nd, Sm, Eu, Gd, Tb, Dy, Ho, Er et Tm,

$$0 \leq x \leq 0{,}2 \; ; \; 0 \leq y \leq 0{,}2 \; ; \; 0 < x{+}y \leq 0{,}4 \; ;$$

$$0 \leq z < 1 \; ; \; x + y + z < 1 \; ;$$

$$0 \leq n \leq 0{,}75 \; ;$$

$$0 \leq a \leq 2 \; ; \; 0 \leq b \leq 2 \; ; \; 0 \leq c \leq 4 \; ; \; 0 \leq d \leq 4 \; ; \; 0 \leq e \leq 4 \; ;$$

$$a + b = 2 \; ; \; c + d + e = 4 \; ;$$

et

$$a + 2b + 3c + 4d + 5e + y - z = 16 - n.$$

**10.** Luminophore selon la revendication 9, dans lequel z + a > 0, $0 \leq b \leq 0{,}5$, M comprend du Ba, et dans lequel x + y + z < 0,15, et dans lequel A comprend du Li, et dans lequel a > 1,5.

**11.** Luminophore selon l'une quelconque des revendications 9 et 10, dans lequel

B est Ba,
C est choisi dans l'ensemble constitué par Al et Ga,
D est le Si tétravalent,
ES est l'Eu divalent,
RE est choisi dans l'ensemble constitué par les éléments trivalents Ce, Pr, Sm, Gd, Tb et Dy, dans lequel $0 \leq b \leq 0{,}5$, $0 < x \leq 0{,}2$, et dans lequel y/x < 0,1 et $n \leq 0{,}1$.

**12.** Luminophore selon l'une quelconque des revendications 9 à 11, lequel luminophore comprend $M_{1-x}Li_{2-q}Mg_qAl_{2+q+n}N_{6-n}O_n$:$Eu_x$ où $n \leq 0{,}05$ et $0 \leq q \leq 0{,}4$, et où M comprend du Ba.

**13.** Luminophore selon l'une quelconque des revendications 9 à 12, dans lequel RE comprend du Ce, et dans lequel x/y < 0,1 et $n \leq 0{,}1$.

**14.** Luminophore selon l'une quelconque des revendications 9 à 13, lequel luminophore comprend des particules de luminophore ayant un revêtement, dans lequel le revêtement comprend un ou plusieurs revêtements choisis dans l'ensemble constitué par un revêtement en $AlPO_4$, un revêtement en $Al_2O_3$ et un revêtement en $SiO_2$.

**15.** Dispositif d'affichage LCD comprenant l'unité d'éclairage de l'une quelconque des revendications 1 à 8 configurée sous la forme d'une unité de rétroéclairage.

**16.** Luminaire comprenant l'unité d'éclairage selon l'une quelconque des revendications 1 à 8.

EP 3 049 505 B1

FIG. 1A

FIG. 1B

FIG. 1C

22

FIG. 1D

FIG. 2A

FIG. 2B

FIG. 3A

FIG. 3B

FIG. 3C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006011922 A
- EP 1930393 A
- EP 1666563 A

**Non-patent literature cited in the description**

- **WATANABE et al.** Synthesis of Sr0.99Eu0.01AlSiN3 from intermetallic precursor. *Journal of the Ceramic Society of Japan,* 2009, vol. 117, 115-119
- **ZEUNER et al.** *Li2CaSi2N4 and Li2SrSi2N4 - a Synthetic Approach to Three-Dimensional Lithium Nitridosilicates European Journal of Inorganic Chemistry,* 2010, 4945-495
- **LI et al.** Low-Temperature Crystallization of Eu-Doped Red-Emitting CaAlSiN3 from Alloy-Derived Ammonometallates. *Chemistry of Materials,* 2007, vol. 19, 3592-3594
- **CHO et al.** Control of AlPO4-nanoparticle coating on LiCoO2 by using water or ethanol. *Electrochimica Acta,* 2005, vol. 50, 4182-4187
- **AVCI, N. ; MUSSCHOOT, J. ; SMET, P.F. ; KORTHOUT, K. ; AVCI, A. ; DETAVERNIER, C. ; POELMAN, D.** Microencapsulation of Moisture-Sensitive CaS:Eu2+ Particles with Aluminum Oxide. *J. Electrochem. Soc.,* 2009, vol. 156, J333-J337